# EUROPÄISCHE PATENTSCHRIFT

(11) **EP 3 203 513 B1**
(45) Veröffentlichungstag und Bekanntmachung des Hinweises auf die Patenterteilung: **02.01.2019**
(21) Anmeldenummer: 17152186.7
(22) Anmeldetag: 19.01.2017
(51) Int. Cl.: H01L 23/367

(54) **KONTAKTSYSTEM MIT EINEM SCHALTUNGSTRÄGER UND BAUELEMENT**
CONTACT SYSTEM WITH A CIRCUIT CARRIER AND COMPONENT
SYSTÈME DE CONTACT COMPRENANT UN PORTE-CIRCUIT ET ÉLÉMENT STRUCTUREL

(30) Priorität: 05.02.2016 DE 102016201797
(43) Veröffentlichungstag der Anmeldung: 09.08.2017
(73) Patentinhaber: Robert Bosch GmbH, 70442 Stuttgart (DE)
(72) Erfinder: Gera, Guenter, 71229 Leonberg (DE)

(56) Entgegenhaltungen:
- EP-A2- 0 920 055
- WO-A1-2014/009234
- WO-A1-2014/171890
- WO-A2-02/056652
- DE-A1- 10 252 577
- JP-A- 2010 267 869
- US-A1- 2006 227 510

## Beschreibung

### Stand der Technik

Aus dem Dokument WO02/056652 ist ein Verfahren zur Herstellung einer elektronischen Baugruppe auf einer Leiterplatte bekannt, wobei elektrische und thermische Vias in der Leiterplatte verschlossen werden.

Aus dem Dokument DE10252577 ist ein Verfahren zum Erzeugen einer Lotverbindung durch kapillaren Lotfluss bekannt, wobei ein Lotdepot vorgesehen ist, welches durch Erwärmen aufschmilzt und durch Kapillarkräfte in einen Verbindungsbereich gezogen wird, um die Lötpartner durch eine Verbindungsschicht zu verbinden.

### Offenbarung der Erfindung

Die Erfindung betrifft ein Kontaktsystem mit einem Schaltungsträger gemäß Anspruch 1. Der Schaltungsträger weist wenigstens eine Substratschicht und wenigstens eine elektrisch leitfähige Schicht auf. Das Kontaktsystem weist wenigstens ein mit dem Schaltungsträger verbundenes elektrisches Bauelement, insbesondere Halbleiterbauelement auf. Bevorzugt ist eine Kontaktfläche, insbesondere eine elektrische Kontaktfläche und/oder eine Wärmekontaktfläche des Bauelements mit dem Schaltungsträger, insbesondere der elektrisch leitfähigen Schicht, mittels eines Lotmittels stoffschlüssig und wärmeleitfähig verbunden, insbesondere verlötet. Die elektrisch leitfähige Schicht ist bevorzugt mit wenigstens einem durch die elektrische Kontaktfläche und/oder die Wärmekontaktfläche abgedeckten Via-Kontakt des Schaltungsträgers wärmeleitfähig oder zusätzlich elektrisch verbunden.

Das Bauelement weist bevorzugt an der elektrischen Kontaktfläche und/oder der Wärmekontaktfläche wenigstens eine ein Reservoir bildende Vertiefung oder Ausnehmung auf. Bevorzugt ist ein sich zwischen der elektrischen Kontaktfläche und/oder der Wärmekontaktfläche und dem Schaltungsträger, insbesondere einer Oberfläche des Schaltungsträgers, erstreckender, ein Lotmittel führender Spalt im Bereich der Vertiefung größer ausgebildet, als in einem die Vertiefung umgebenden Bereich. Bevorzugt ist ein Querdurchmesser einer Öffnung des Via-Kontakts größer ausgebildet, als ein Spaltmaß des Lotspalts im Bereich der Vertiefung.

Dadurch kann mittels der Vertiefung ein Reservoir für überschüssiges Lotmittel gebildet sein, wobei das Reservoir ausgebildet ist, eine Kapillarkraft für verflüssigtes Lotmittel auszubilden. Dadurch kann vorteilhaft ein Querradius einer an einer Grenzfläche des Lotmittels gebildeten Krümmung kleiner sein als ein Querradius an einer gekrümmten Grenzfläche eines in den Via-Kontakt eindringenden Lotmittels.

Das Bauelement ist bevorzugt ein elektrisches und/oder elektronisches Bauelement, das eine Kontaktfläche, insbesondere eine Wärmekontaktfläche und/oder eine elektrische Kontaktfläche zum Verlöten mit einem Schaltungsträger aufweist. Vorteilhafte Beispiele für ein Bauelement mit einer elektrischen Kontaktfläche und/oder Wärmekontaktfläche sind eine Spule, ein Kondensator, ein Quarz oder ein Sensor. Beispiele für einen Sensor sind ein Strahlenempfänger für elektromagnetische Strahlen, ein Temperatursensor, ein Beschleunigungssensor oder ein Lagesensor.

Weitere Beispiele für ein solches Bauelement sind elektromechanische Bauelemente wie Einschraubhülsen, Kontaktplättchen, Buchsen oder Stecker.

Die Vertiefung ist beispielsweise mittels Ätzen, Stanzen, Sägen Prägen, Bohren, Laserschneiden oder Fräsen erzeugt.

Bevorzugt kann der Spalt im Bereich der das Reservoir bildenden Vertiefung eine größere Kapillarkraft ausbilden, als die Via-Durchkontaktierung des Schaltungsträgers. So können vorteilhaft mittels des Lotreservoirs Toleranzen des Spaltes zwischen dem Schaltungsträger und dem Bauelement, insbesondere der elektrischen Kontaktfläche und/oder Wärmekontaktfläche des Bauelements, kompensiert werden, da so ein überschüssiges Lotmaterial beim Reflow-Löten in der Vertiefung durch Kapillarkraft aufgenommen werden kann. Dadurch kann ein nicht beabsichtigtes Hineinfließen des Lotmittels beim Reflow-Löten in den Via-Kontakt vorteilhaft verhindert werden.

Der sich zwischen der elektrischen Kontaktfläche und/oder der Wärmekontaktfläche und dem Schaltungsträger erstreckende Spalt - außerhalb der erwähnten Vertiefung - kann so vorteilhaft für geschmolzenes Lotmittel eine größere Kapillarkraft ausbilden, als der Spalt im Bereich der Vertiefung, wobei der Spalt im Bereich der Vertiefung eine noch hinreichende Kapillarkraft ausbilden kann, um überschüssiges, geschmolzenes Lotmittel aufzunehmen. Bevorzugt ist der Spalt im Bereich der Vertiefung ausgebildet, für geschmolzenes Lotmittel eine größere Kapillarkraft, insbesondere eine hinreichend größere Kapillarkraft auszubilden, als die Via-Durchkontaktierung, insbesondere eine hohl ausgebildete Via-Kontaktierung.

Die Via-Kontaktierung, insbesondere ein von der Via-Durchkontaktierung umschlossener Hohlraum, erstreckt sich bevorzugt quer zu einer ebenen Erstreckung des Schaltungsträgers. Die Via-Durchkontaktierung, insbesondere der umschlossene Hohlraum der Via-Kontaktierung, bildet einen insbesondere zylinderförmigen Durchbruch in dem Schaltungsträger.

Bevorzugt beträgt ein Querdurchmesser des Via-Kontaktes zwischen 300 und 700 Mikrometer. Bevorzugt beträgt der Durchmesser des Via-Kontaktes 500 Mikrometer. Der Via kann so aufwandsgünstig mittels Bohren erzeugt werden.

In einer bevorzugten Ausführungsform beträgt ein Spaltmaß eines Spaltes im Bereich der Vertiefung in der elektrischen Kontaktfläche und/oder der Wärmekontaktfläche des Bauelements mehr als das Doppelte, bevorzugt mehr als das Dreifache des Spaltmaßes des Spaltes zwischen dem Schaltungsträger und dem Bauelement, in dem die Vertiefung umgebenden Bereich der elektrischen Kontaktfläche und/oder der Wärmekontaktfläche. So kann vorteilhaft ein großes Lotreservoir gebildet sein, sodass ein Schaltungsaufbau auf dem Schaltungsträger, insbesondere eine Schaltungsanordnung, kompakt und platzsparend auf dem Schaltungsträger angeordnet sein kann. Vorteilhaft kann ein Spaltvolumen im Reservoir um den Faktor des mit der Vertiefung vergrößerten Spaltmaßes vergrößert sein, so dass Lotmittel in dem Reservoir aufgenommen werden kann.

Weiter vorteilhaft kann so eine elektrisch leitfähige Hülse, welche die Via-Durchkontaktierung bildet, beispielsweise eine Kupferhülse, erzeugt durch Galvanisieren, mit einer elektrisch leitfähigen Schicht, welche sich an einer Oberfläche des Schaltungsträgers erstreckt, wärmeleitfähig und elektrisch verbunden sein. Vorteilhaft braucht bei einer solchen Verbindung bei dem Kontaktsystem kein Lötstopplack oder eine Unterbrechung der Leiterbahnen zwischen dem Via-Kontakt und der elektrisch leitfähigen Schicht vorgesehen sein, welche mit der elektrischen Kontaktfläche und/oder der Wärmekontaktfläche wärmeleitfähig verbunden, insbesondere mittels eines Lotmittels verlötet ist. So kann das Kontaktsystem, insbesondere als Bestandteil einer Schaltungsanordnung, platzsparend aufgebaut sein.

Bevorzugt beträgt das Spaltmaß im Bereich der elektrischen Kontaktfläche und/oder der Wärmekontaktfläche bis zu 150 Mikrometer, bevorzugt zwischen 30 und 150 Mikrometer. Bevorzugt beträgt das Spaltmaß im Bereich der Vertiefung zwischen 100 und 400 Mikrometer. Es wurde nämlich gefunden, dass eine Kapillarkraft für verflüssigtes Lotmittel bei einem solchen Spaltmaß des Reservoirs noch hinreichend gut ausgebildet sein kann.

Bevorzugt ist die Vertiefung von einem Rand der elektrischen Kontaktfläche und/oder der Wärmekontaktfläche beabstandet, so dass die Vertiefung von einem Rand der elektrischen Kontaktfläche und/oder der Wärmekontaktfläche des Bauelements eingeschlossen ist. Beispielsweise beträgt ein Abstand des Reservoirs vom Rand der elektrischen Kontaktfläche und/oder der Wärmekontaktfläche wenigstens einen Millimeter, bevorzugt zwischen einem und fünf Millimeter. So kann das Reservoir auf einer dem Schaltungsträger zugewandten Seite des Bauelements platzsparend angeordnet sein.

In einer bevorzugten Ausführungsform ist wenigstens eine ein Reservoir ausbildende Vertiefung als sich längs erstreckender Graben ausgebildet. So kann das Lotmittel vorteilhaft in den Graben, welcher das Reservoir bildet, hineingesaugt werden.

In einer bevorzugten Ausführungsform verlaufen wenigstens zwei jeweils ein Reservoir ausbildende, sich längs erstreckende Gräben in der Ebene der elektrischen Kontaktfläche und/oder der Wärmekontaktfläche zueinander parallel. So kann überschüssiges Lotmittel vorteilhaft von zueinander verschiedenen Bereichen der elektrischen Kontaktfläche und/oder der Wärmekontaktfläche über die Gräben sicher aufgenommen werden. Weiter vorteilhaft lässt sich das Reservoir so aufwandsgünstig - beispielsweise durch Einprägen oder Ausfräsen der elektrischen Kontaktfläche und/oder der Wärmekontaktfläche - bereitstellen.

In einer bevorzugten Ausführungsform sind wenigstens zwei in einer ebenen Erstreckung der elektrischen Kontaktfläche und/oder der Wärmekontaktfläche ausgebildete, jeweils ein Reservoir bildende Gräben gebildet, welche einander überkreuzen. So kann vorteilhaft eine gute Flächenabdeckung von Reservoirs gebildet sein.

In einer bevorzugten Ausführungsform ist durch die jeweils ein Reservoir bildenden Gräben ein Gittermuster gebildet. Die Gräben mit der guten Flächenabdeckung können so vorteilhaft aufwandsgünstig bereitgestellt werden. Die das Gittermuster bildenden Gräben sind beispielsweise mittels Ätzen, Stanzen, Sägen Prägen, Laserschneiden oder Fräsen erzeugt.

In einer bevorzugten Ausführungsform ist wenigstens eine ein Reservoir bildende Vertiefung kalottenförmig oder zylinderförmig ausgebildet. So kann das Reservoir vorteilhaft auf einen kleinen Ort der elektrischen Kontaktfläche und/oder der Wärmekontaktfläche- insbesondere in der Nähe eines Via-Kontaktes - begrenzt sein, um dort Lotmittel sicher aufzunehmen.

In einer bevorzugten Ausführungsform ist wenigstens eine Vertiefung kurvenförmig oder kreisförmig ausgebildet. So kann eine oder eine zusammenliegende Gruppe von Via-Kontaktierungen vorteilhaft von einem Lotreservoir umgeben oder eingeschlossen sein.

Bevorzugt beträgt ein Abstand des Reservoirs zu einem Via-Kontakt hin in einer ebenen Erstreckung des Schaltungsträgers zwischen einem Millimeter und 10 Millimeter. Dadurch kann überschüssiges Lotmittel noch sicher im Reservoir aufgenommen werden.

In einer bevorzugten Ausführungsform ist wenigstens ein Via-Kontakt mit einer Wärmesenke wärmeleitfähig verbunden, welche auf einer zu dem Bauteil gegenüberliegenden Seite des Schaltungsträgers angeordnet ist. Die Wärmesenke ist beispielsweise durch einen Kühlkörper, insbesondere einen Kupferkühlkörper oder Aluminiumkühlkörper, gebildet.

Der Kühlkörper kann beispielsweise Kühlrippen aufweisen oder wenigstens einen zum Fluidführen ausgebildeten Hohlraum, über den - über ein Kühlfluid, beispielsweise Öl oder Wasser - Verlustwärme abgeführt werden kann.

Die Erfindung betrifft auch ein elektrisches und/oder elektronisches Bauelement, insbesondere Halbleiterbauelement, für ein Kontaktsystem der vorbeschriebenen Art gemäß Anspruch 12. Das Das Bauelement weist eine insbesondere eben ausgebildete elektrische Kontaktfläche und/oder Wärmekontaktfläche zum Abführen von Verlustwärme an eine Wärmesenke, insbesondere einen Schaltungsträger auf. Das Bauelement weist bevorzugt an der elektrischen Kontaktfläche und/oder der Wärmekontaktfläche ausgebildete, wenigstens eine ein Reservoir bildende Vertiefung oder Ausnehmung auf, so dass ein sich zwischen der elektrischen Kontaktfläche und/oder der Wärmekontaktfläche und dem Schaltungsträger, insbesondere einer Oberfläche des Schaltungsträgers, erstreckender Spalt zum Führen eines Lotmittels im Bereich der Vertiefung größer ausgebildet ist, als in einem die Vertiefung umgebenden Bereich. Bevorzugt ist die Vertiefung von einem Rand der elektrischen Kontaktfläche und/oder der Wärmekontaktfläche beabstandet, so dass die Vertiefung von einem Rand der elektrischen Kontaktfläche und/oder der Wärmekontaktfläche des Bauelements eingeschlossen ist. So kann vorteilhaft ein Flip-Chip-Bauelement als Halbleiterbauelement das Reservoir an seiner Wärmekontaktseite aufweisen.

Die Erfindung wird nun im Folgenden anhand von Figuren und weiteren Ausführungsbeispielen beschrieben. Weitere vorteilhafte Ausführungsformen ergeben sich aus den in den Figuren und in den abhängigen Ansprüchen beschriebenen Merkmalen.

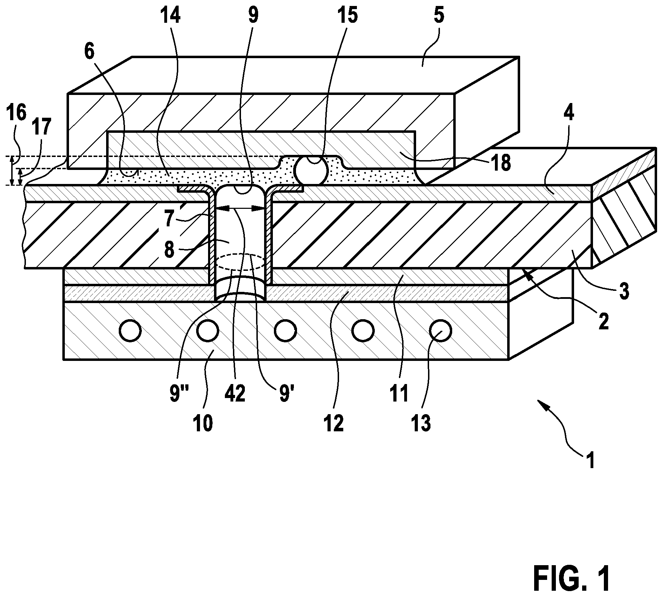

Figur 1 zeigt ein Ausführungsbeispiel für ein Kontaktsystem, bei dem ein sich zwischen einem Schaltungsträger und einer elektrischen Kontaktfläche und/oder einer Wärmekontaktfläche als Grenzfläche eines Bauelements im Bereich eines Reservoirs erstreckender Spalt für verflüssigtes Lotmittel eine Kapillarkraft erzeugen kann, die größer ausgebildet ist, als eine von einem Via-Kontakt ausbildbare Kapillarkraft für das verflüssigte Lotmittel;

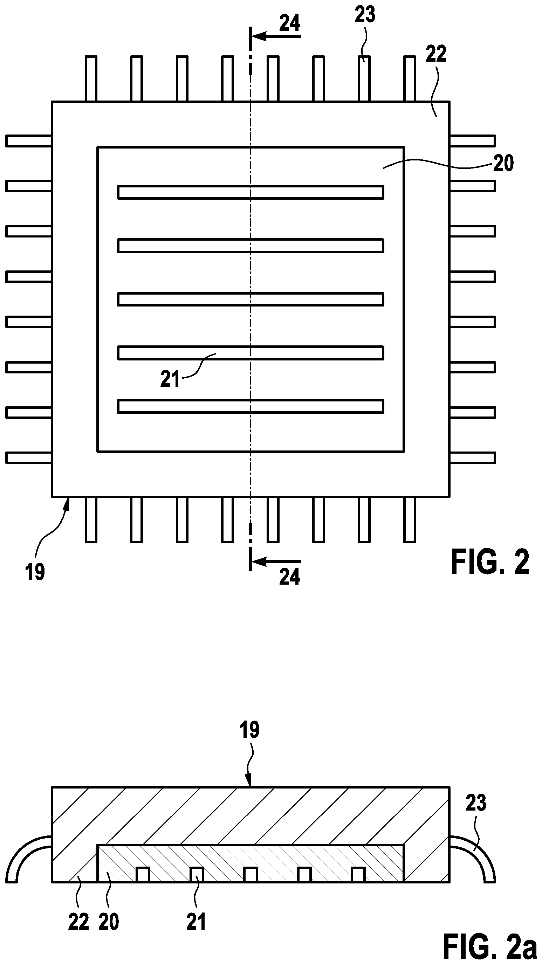

Figur 2 zeigt ein Ausführungsbeispiel für ein Bauelement, insbesondere Halbleiterbauelement, das in einer sich eben erstreckenden elektrischen Kontaktfläche und/oder Wärmekontaktfläche sich längserstreckende, furchenartige Vertiefungen aufweist, die jeweils ein Reservoir für verflüssigtes Lotmittel ausbilden können;

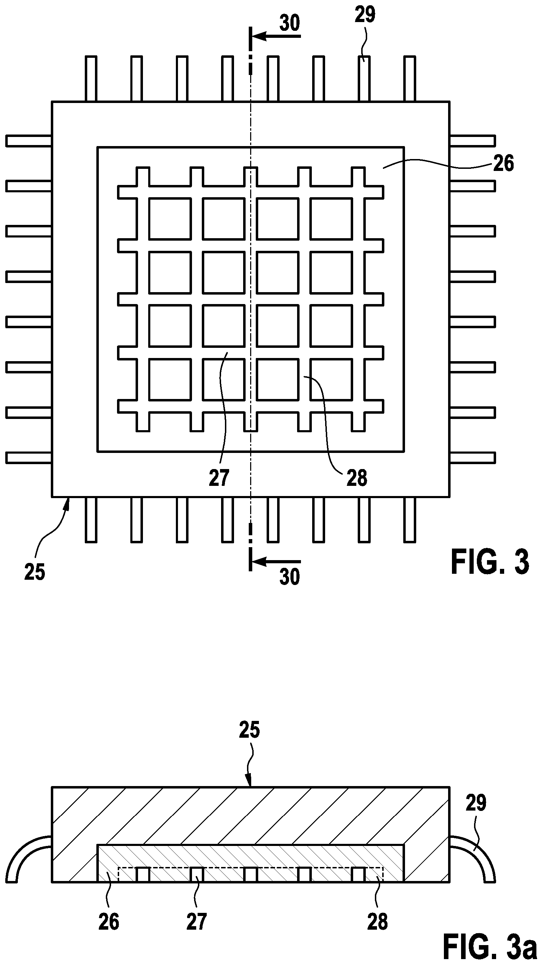

Figur 3 zeigt ein Ausführungsbeispiel für ein Bauelement, insbesondere ein Halbleiterbauelement, das in einer sich eben erstreckenden elektrischen Kontaktfläche und/oder Wärmekontaktfläche sich längserstreckende, furchenartige Vertiefungen aufweist, die jeweils ein Reservoir für verflüssigtes Lotmittel ausbilden können und welche einander überkreuzt ausgebildet sind;

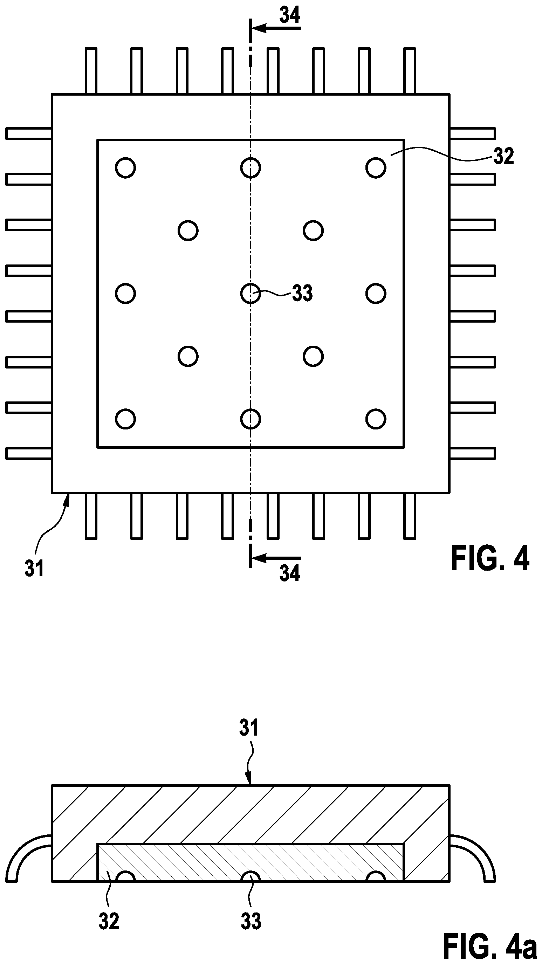

Figur 4 zeigt ein Ausführungsbeispiel für ein Bauelement, insbesondere ein Halbleiterbauelement, das in einer sich eben erstreckenden elektrischen Kontaktfläche und/oder Wärmekontaktfläche gemeinsam ein Punktmuster ausbildende halbkalottenförmige Vertiefungen aufweist, die jeweils ein Reservoir für verflüssigtes Lotmittel ausbilden können;

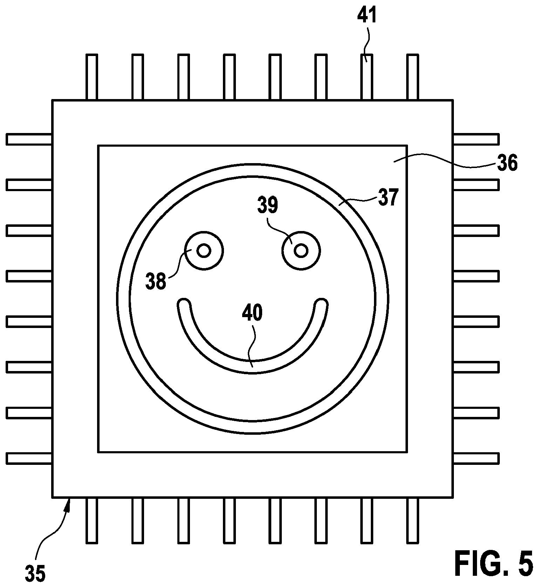

Figur 5 zeigt ein Ausführungsbeispiel für ein Bauelement, insbesondere ein Halbleiterbauelement das in einer sich eben erstreckenden elektrischen Kontaktfläche und/oder Wärmekontaktfläche kurvenförmige Vertiefungen aufweist, die jeweils ein Reservoir für verflüssigtes Lotmittel ausbilden können.

Figur 1 zeigt ein Ausführungsbeispiel für ein Kontaktsystem 1. Das Kontaktsystem 1 umfasst einen Schaltungsträger 2. Der Schaltungsträger 2 umfasst wenigstens eine Substratschicht 3 und wenigstens eine elektrisch leitfähige Schicht 4. Das Kontaktsystem 1 weist auch ein Bauelement 6, insbesondere ein Halbleiterbauelement 5 auf, welches mit dem Schaltungsträger 2 wärmeleitfähig mittels eines Lotmittels 14 verbunden ist. Dazu weist das Bauelement 5 eine elektrische Kontaktfläche und/oder Wärmekontaktfläche 6 auf, welche mittels des Lotmittels 14 mit der elektrisch leitfähigen Schicht 4 des Schaltungsträgers 2 verlötet, und so wärmeleitfähig verbunden ist.

Der Schaltungsträger 2 weist in diesem Ausführungsbeispiel einen Via-Kontakt 7 auf, welcher einen Durchbruch in dem Schaltungsträger 2 bildet. Der Via-Kontakt 7 ist durch eine elektrisch leitfähige Hülse gebildet, welche beispielsweise galvanisch erzeugt ist oder durch eine Niethülse gebildet sein kann. Der Via-Kontakt 7 umschließt in diesem Ausführungsbeispiel einen zylindrisch ausgebildeten Hohlraum 8.

In diesem Ausführungsbeispiel ist auf der gegenüberliegenden Seite des Schaltungsträgers 2 eine Wärmesenke, in diesem Ausführungsbeispiel ein Kühlkörper 10, angeordnet. Der Kühlkörper 10 ist mittels einer elektrischen Isolierschicht 12, welche auch wärmeleitfähig ausgebildet ist, auch TIM-Schicht (TIM = Thermal-Insulation-Material) genannt, mit dem Schaltungsträger 2 wärmeleitfähig und elektrisch isoliert verbunden. Die elektrische Isolierschicht 12 ist dabei an eine elektrisch leitfähige Schicht 11 des Schaltungsträgers, welche zu der Wärmesenke, insbesondere dem Kühlkörper 10, hin eine Außenseite bildet, wärmeleitfähig angekoppelt. So kann Verlustwärme von dem Bauelement 5 über das Lotmittel 14 und weiter über die elektrisch leitfähige Schicht, die Substratschicht 3, die elektrisch leitfähige Schicht 11 und die elektrische wärmeleitfähig ausgebildete Isolierschicht 12 bis hin zur Wärmesenke, gebildet durch den Kühlkörper 10, hin fließen. Die Verlustwärme kann beispielsweise durch ein in einem Fluidkanal 13, welcher in dem Kühlkörper 10 ausgebildet ist, fließendes Kühlfluid, beispielsweise Kühlwasser, abgeführt werden. Anders als in Figur 1 dargestellt, kann der Kühlkörper 10 zusätzlich oder unabhängig zu dem Fluidkanal wie dem Fluidkanal 13 Kühlrippen aufweisen.

Das Bauelement 5 weist in diesem Ausführungsbeispiel ein Wärmekontaktmetall 18 auf, welches in diesem Ausführungsbeispiel ein Inlay in dem Bauelement 5, insbesondere in einem Mold-Körper des Bauelements 5, bildet. Das Wärmekontaktmetall, welches beispielsweise durch einen Metallkörper oder ein Blechstück gebildet ist, weist die elektrische Kontaktfläche und/oder die Wärmekontaktfläche 6 auf, welche ausgebildet ist, mit dem Schaltungsträger 2 lotverbunden zu werden.

Das Bauelement 5, in diesem Ausführungsbeispiel das Wärmekontaktmetall 18, weist wenigstens eine Ausnehmung oder Vertiefung 15 auf, welche ein Reservoir für überschüssiges Lotmittel wie das Lotmittel 14 bildet.

Ein Spalt 17, welcher sich zwischen der elektrischen Kontaktfläche und/oder der Wärmekontaktfläche 6 - benachbart zu der Vertiefung, die das Reservoir 15 bildet - erstreckt, weist in diesem Ausführungsbeispiel eine kleinere Spalthöhe zu dem Schaltungsträger 2, insbesondere der elektrisch leitfähigen Schicht, hin auf, als der Spalt 16, welcher sich im Bereich der Vertiefung, die das Reservoir 15 bildet und dem Schaltungsträger 2, insbesondere der elektrisch leitfähigen Schicht 4, erstreckt. So kann das Reservoir 15 überschüssiges Lotmittel beim Verlöten aufnehmen, sodass eine Grenzfläche 9 zu dem Via-Kontakt 7 hin ausgebildet werden kann, bei der das Lotmittel 14 nicht oder nur geringfügig in den Hohlraum 8 des Via-Kontakts 7 eindringt.

Dazu ist eine Kapillarkraft des Spaltes 16 im Bereich des Reservoirs 15 größer ausgebildet als eine Kapillarkraft für verflüssigtes Lotmittel 14, welche der Via-Kontakt 7 ausbilden kann.

Ein Querdurchmesser 42 des Via-Kontakts 7 ist dazu in diesem Ausführungsbeispiel größer ausgebildet, als eine Spalthöhe des Spaltes 16 im Bereich der Vertiefung, die das Reservoir 15 ausbildet.

Ohne das Reservoir 15 könnte beim Reflow-Verlöten des Schaltungsträgers 2 mit dem Bauelement 5 überschüssiges geschmolzenes Lotmittel 14 in den Hohlraum 8 eindringen und dort beispielsweise bis zu einer Grenzschicht 9' vordringen oder den Durchbruch, gebildet durch den Via-Kontakt 7, wie durch die Grenzfläche 9" angedeutet, durchdringen und auf einer zu dem Bauelement 5 gegenüberliegenden Seite wieder austreten und dort - beispielsweise an dem Kühlkörper 10 als Wärmesenke - einen Kurzschluss verursachen.

Das Bauelement 5 kann beispielsweise durch einen integrierten Schaltkreis, einen Halbleiterschalter oder einen Logik-Schaltkreis, beispielsweise einen Mikrocontroller, einen Mikroprozessor, ein FPGA (FPGA = Field-Programmable-Gate-Array) oder ein ASIC (Application-Specific-Integrated-Circuit) gebildet sein.

Figur 2 zeigt ein Ausführungsbeispiel für ein Bauelement 19, insbesondere ein Halbleiterbauelement 19, welches einen Mold-Körper 22 aufweist und ein von dem Mold-Körper 22 umschlossenes Wärmeleitelement 20. Das Wärmeleitelement 20 bildet in diesem Ausführungsbeispiel einen Metallkörper, welcher - wie der Metallkörper 18 des Bauelement 5 - eine elektrische Kontaktfläche und/oder Wärmekontaktfläche wie die elektrische Kontaktfläche und/oder Wärmekontaktfläche 6 aufweist, welche einen Oberflächenbereich des Bauelement 19 ausbildet und welche sich eben erstreckend ausgebildet ist.

Das Wärmeleitelement 20 weist an der elektrischen Kontaktfläche und/oder der Wärmekontaktfläche in diesem Ausführungsbeispiel sich fünf zueinander parallel erstreckende und voneinander beabstandete sich längs erstreckende Vertiefungen auf, von denen eine Vertiefung 21 beispielhaft bezeichnet ist. Das Bauelement 19 kann - anders als in Figur 2 dargestellt - auch weniger als fünf sich längs erstreckende Vertiefungen oder mehr als fünf sich längs erstreckende Vertiefungen aufweisen. Die sich längs erstreckenden Vertiefungen, wie die Vertiefung 21, bilden jeweils ein Reservoir für verflüssigtes Lotmittel, wie das in Figur 1 bereits dargestellte Lotmittel 14. Die Vertiefungen 21 können im Bereich der Vertiefung gemeinsam mit einem Schaltungsträger, beispielsweise dem in Figur 1 dargestellten Schaltungsträger 2, einen Kapillarspalt ausbilden, welcher ausgebildet ist, verflüssigtes Lotmittel mit einer stärkeren Kapillarkraft aufzunehmen, als ein Via-Kontakt wie der in Figur 1 dargestellte Via-Kontakt 7.

Das Bauelement 19 weist in diesem Ausführungsbeispiel auch entlang eines Umfangs des Bauelements angeordnete elektrische Anschlüsse auf, insbesondere Anschlussbeine, von denen ein elektrischer Anschluss 23 beispielhaft bezeichnet ist.

Figur 2a zeigt das in Figur 2 dargestellte Bauelement 19 in einer Schnittdarstellung entlang einer Schnittlinie 24. Sichtbar ist die Vertiefung 21, welche in dem Wärmeleitelement 20 eine Art Rinne oder Graben ausbildet.

Figur 3 zeigt ein Ausführungsbeispiel für ein Bauelement 25, insbesondere ein Halbleiterbauelement 25. Das Bauelement 25 weist wie das in Figur 1 bereits dargestellte Bauelement 5 einen Mold-Körper 22 auf, in dem ein Wärmeleitelement 26 derart umschlossen ist, dass eine elektrische Kontaktfläche und/oder Wärmekontaktfläche des Wärmeleitelements 26 einen Oberflächenbereich des Bauelement 25 ausbildet. Das Bauelement 25 kann so über die elektrische Kontaktfläche und/oder die Wärmekontaktfläche Verlustwärme abführen.

Das Wärmeleitelement 26 weist in diesem Ausführungsbeispiel fünf zueinander parallel beabstandete, furchenartige Vertiefungen auf, von denen eine Vertiefung 28 beispielhaft bezeichnet ist.

Das Bauelement 25, insbesondere das Wärmekontaktmetall 26, weist in diesem Ausführungsbeispiel fünf weitere sich zueinander parallel erstreckende, grabenartige Vertiefungen auf, welche sich jeweils quer zu den zuvor genannten Vertiefungen, wie die Vertiefung 28 erstrecken und von denen eine Vertiefung 27 beispielhaft bezeichnet ist. Die Vertiefung 27 und die Vertiefung 28 überkreuzen einander, sodass durch die in Figur 3 dargestellten insgesamt zehn Vertiefungen eine Art Schachbrettmuster gebildet ist.

Das Bauelement 25 weist auch elektrische Anschlüsse auf, welche an dem Mold-Körper umlaufend angeordnet sind und von denen ein elektrischer Anschluss 29 beispielhaft bezeichnet ist.

Figur 3a zeigt eine Schnittdarstellung des in Figur 3 bereits dargestellten Bauelement 25 entlang einer Schnittlinie 30. Sichtbar sind die furchen- oder grabenartigen Vertiefungen, wie die Vertiefung 27 in dem Wärmeleitelement 26.

Figur 4 zeigt ein Ausführungsbeispiel für ein Bauelement 31, insbesondere ein Halbleiterbauelement 31, welches - wie das Bauelement 5 in Figur 1 - ein Wärmekontaktmetall 32 aufweist. In dem Wärmekontaktmetall 32 sind in diesem Ausführungsbeispiel dreizehn, jeweils gleichmäßig zueinander beabstandet angeordnete Vertiefungen ausgebildet, von denen eine Vertiefung 33 beispielhaft bezeichnet ist. Die Vertiefungen wie die Vertiefung 33 sind in diesem Ausführungsbeispiel halbkalottenförmig ausgebildet.

Anders als in Figur 4 dargestellt, können die Vertiefungen wie die Vertiefung 33 auch hohlzylinderförmig ausgebildet sein.

Die Vertiefungen wie die Vertiefung 33 sind jeweils ausgebildet, eine Kapillarkraft in Verbindung mit einem Schaltungsträger wie dem in Figur 1 dargestellten Schaltungsträger 2 auszubilden, welcher kleiner ausgebildet ist als eine Kapillarkraft im Bereich der elektrischen Kontaktfläche und/oder der Wärmekontaktfläche, an der keine Vertiefung ausgebildet ist.

Die Vertiefungen wie die Vertiefung 33 können so vorteilhaft ein Reservoir für überschüssiges, geschmolzenes Lotmittel ausbilden.

Figur 4a zeigt das in Figur 4 gezeigte Bauelement 31 in einer Schnittdarstellung entlang der Schnittlinie 34. Sichtbar ist die kalottenförmige Vertiefung 33.

Figur 5 zeigt ein Ausführungsbeispiel für ein Bauelement 35, insbesondere ein Halbleiterbauelement 35. Das Bauelement 35 weist ein in einen Mold-Körper eingeschlossenes Wärmekontaktmetall 36 auf, an dem eine elektrische Kontaktfläche und/oder Wärmekontaktfläche wie die in Figur 1 dargestellte elektrische Kontaktfläche und/oder Wärmekontaktfläche 6 ausgebildet ist. Das Wärmeleitelement 36 weist in diesem Ausführungsbeispiel grabenförmige Vertiefungen 37, 38, 39 und 40 auf, welche jeweils in einer ebenen Erstreckung der elektrischen Kontaktfläche und/oder der Wärmekontaktfläche eine Kurvenform, insbesondere Kreiskurvenform, ausbilden. Die Vertiefung 37 bildet in diesem Ausführungsbeispiel eine Kreiskurvenform aus. Die Vertiefungen 38 und 39 bilden jeweils eine Kreiskurvenform aus und sind von der Kreiskurvenform der Vertiefung 37 eingeschlossen. Die Vertiefung 40 bildet in diesem Ausführungsbeispiel einen Kreisbogenabschnitt aus und ist von der durch die Vertiefung 37 gebildeten Kreisform umschlossen.

Die Vertiefungen wie die Vertiefungen 37, 38, 39 und 40 können jeweils ein Reservoir für überschüssiges Lotmittel wie das in Figur 1 dargestellte Lotmittel 14 ausbilden. Dadurch kann ein von dem Wärmeleitelement 36 abgedeckter Via-Kontakt, wie der in Figur 1 dargestellte Via-Kontakt 7, von verflüssigtem Lotmittel freigehalten werden.

Die elektrische Kontaktfläche und/oder Wärmekontaktfläche des Wärmeleitelements 36 ist in diesem Ausführungsbeispiel eben ausgebildet.

Das Wärmekontaktmetall wie das Wärmekontaktmetall des Wärmeleitelements 36 kann beispielsweise durch Kupfer oder durch Aluminium gebildet sein.

## Patentansprüche

1. Kontaktsystem (1) mit einem Schaltungsträger (2), wobei der Schaltungsträger (2) wenigstens eine Substratschicht (3) und wenigstens eine elektrisch leitfähige Schicht (4, 11) aufweist, wobei das Kontaktsystem (1) wenigstens ein mit dem Schaltungsträger (2) verbundenes elektrisches und/oder elektronisches Bauelement, insbesondere ein Halbleiterbauelement (5, 19, 25, 31, 35), aufweist, wobei eine elektrische Kontaktfläche und/oder Wärmekontaktfläche (6) des Bauelement (5) mit dem Schaltungsträger (2), insbesondere der elektrisch leitfähigen Schicht (4) mittels eines Lotmittels (14) stoffschlüssig verbunden ist, und wobei die elektrisch leitfähige Schicht (4) mit wenigstens einem durch die elektrische Kontaktfläche und/oder Wärmekontaktfläche (6) abgedeckten Via-Kontakt (7) elektrisch verbunden ist, **dadurch gekennzeichnet, dass**
das Bauelement (5, 19, 25, 31, 35) an der elektrischen Kontaktfläche und/oder der Wärmekontaktfläche (6) wenigstens eine ein Reservoir (15, 21, 27, 28, 33, 37, 38, 39, 40) bildende Vertiefung oder Ausnehmung aufweist,
wobei ein sich zwischen der elektrischen Kontaktfläche und/oder der Wärmekontaktfläche (6) und dem Schaltungsträger (2) erstreckender, ein Lotmittel (14) führender Spalt (17) im Bereich des Reservoirs (15, 21, 27, 28, 33, 37, 38, 39, 40) größer ausgebildet ist als in einem das Reservoir (15, 21, 27, 28, 33, 37, 38, 39, 40) umgebenden Bereich, und ein Querdurchmesser (42) einer Öffnung des Via-Kontakts (7) größer ausgebildet ist als ein Spaltmass des Lotspalts im Bereich des Reservoirs (15, 21, 27, 28, 33, 37, 38, 39, 40).

2. Kontaktsystem (1) nach Anspruch 1, wobei der Querdurchmesser des Via (7) zwischen 300 und 700 Mikrometer beträgt.

3. Kontaktsystem (1) nach Anspruch 1 oder 2, wobei das Spaltmass eines sich zwischen dem Bauelement (5, 19, 25, 31, 35) und dem Schaltungsträger (2) erstreckenden Spaltes (16) im Bereich des Reservoirs (15, 21, 27, 28, 33, 37, 38, 39, 40), mehr als das Doppelte, bevorzugt mehr als der Dreifache des Spaltmaßes des Spaltes (17) in dem die das Reservoir (15, 21, 27, 28, 33, 37, 38, 39, 40) bildende Vertiefung umgebenden Bereich beträgt.

4. Kontaktsystem (1) nach einem der vorhergehenden Ansprüche, wobei das Spaltmass des Spaltes (17) im Bereich der elektrischen Kontaktfläche und/oder der Wärmekontaktfläche (6) bis zu 150 Mikrometer beträgt.

5. Kontaktsystem (1) nach einem der vorhergehenden Ansprüche, wobei wenigstens eine ein Reservoir (15, 21, 27, 28, 33, 37, 38, 39, 40) bildende Vertiefung als sich längserstreckender Graben ausgebildet ist.

6. Kontaktsystem (1) nach Anspruch 5, wobei wenigstens zwei jeweils ein Reservoir (15, 21, 27, 28, 33, 37, 38, 39, 40) bildende sich längserstreckende Gräben in der Ebene der elektrischen Kontaktfläche und/oder der Wärmekontaktfläche (6) zueinander parallel verlaufen.

7. Kontaktsystem (1) nach Anspruch 5 oder 6, wobei wenigstens zwei in einer ebenen Erstreckung der elektrischen Kontaktfläche und/oder der Wärmekontaktfläche (6) jeweils ein Reservoir (27, 28) ausbildende Gräben ausgebildet sind, welche einander überkreuzen.

8. Kontaktsystem (1) nach einem der Ansprüche 5 bis 7, wobei durch die jeweils ein Reservoir (27, 28) ausbildende Gräben ein Gittermuster gebildet ist.

9. Kontaktsystem (1) nach einem der vorhergehenden Ansprüche, wobei wenigstens eine ein Reservoir (15, 21, 27, 28, 33, 37, 38, 39, 40) bildende Vertiefung kalottenförmig oder Zylinderförmig ausgebildet ist.

10. Kontaktsystem (1) nach einem der vorhergehenden Ansprüche, wobei wenigstens eine ein Reservoir (37, 38, 39, 40) bildende Vertiefung kurvenförmig oder kreisförmig ausgebildet ist.

11. Kontaktsystem (1) nach einem der vorhergehenden Ansprüche, wobei wenigstens ein Via (7) mit einer Wärmesenke (10) wärmeleitfähig verbunden ist, welche auf einer zu dem Bauelement (5) gegenüberliegenden Seite des Schaltungsträgers (2) angeordnet ist.

12. Elektrisches und/oder elektronisches Bauelement (5, 19, 25, 31, 35), insbesondere Halbleiterbauelement, für ein Kontaktsystem (1) gemäß einem der vorhergehenden Ansprüche,
wobei das Bauelement (5, 19, 25, 31, 35) eine insbesondere eben ausgebildete elektrische Kontaktfläche und/oder Wärmekontaktfläche (6) zum Abführen von Verlustwärme an eine Wärmesenke, insbesondere einen Schaltungsträger (2) aufweist und an der elektrischen Kontaktfläche und/oder der Wärmekontaktfläche (6) wenigstens eine ein Reservoir (15, 21, 27, 28, 33, 37, 38, 39, 40) bildende Vertiefung oder Ausnehmung ausgebildet ist, so dass ein sich zwischen der elektrischen Kontaktfläche und/oder der Wärmekontaktfläche (6) und dem Schaltungsträger (2), insbesondere einer Oberfläche des Schaltungsträgers (2), erstreckender Spalt (17) zum Führen eines Lotmittels im Bereich der Vertiefung größer ausgebildet ist als in einem die Vertiefung umgebenden Bereich.

## Claims

1. Contact system (1) comprising a circuit carrier (2), wherein the circuit carrier (2) comprises at least one substrate layer (3) and at least one electrically conductive layer (4, 11), wherein the contact system (1) comprises at least one electrical and/or electronic component connected to the circuit carrier (2), in particular a semiconductor component (5, 19, 25, 31, 35), wherein an electrical contact area and/or thermal contact area (6) of the component (5) is cohesively connected to the circuit carrier (2), in particular the electrically conductive layer (4), by means of a solder (14), and wherein the electrically conductive layer (4) is electrically connected to at least one via contact (7) covered by the electrical contact area and/or the thermal contact area (6),
**characterized in that**
the component (5, 19, 25, 31, 35) comprises at least one depression or recess forming a reservoir (15, 21, 27, 28, 33, 37, 38, 39, 40) at the electrical contact area and/or the thermal contact area (6),
wherein a gap (17) extending between the electrical contact area and/or the thermal contact area (6) and the circuit carrier (2) and guiding a solder (14) is formed such that it is larger in the region of the reservoir (15, 21, 27, 28, 33, 37, 38, 39, 40) than in a region surrounding the reservoir (15, 21, 27, 28, 33, 37, 38, 39, 40), and a transverse diameter (42) of an opening of the via contact (7) is formed such that it is larger than a gap dimension of the solder gap in the region of the reservoir (15, 21, 27, 28, 33, 37, 38, 39, 40).

2. Contact system (1) according to Claim 1,
wherein the transverse diameter of the via (7) is between 300 and 700 micrometres.

3. Contact system (1) according to Claim 1 or 2,
wherein the gap dimension of a gap (16) extending between the component (5, 19, 25, 31, 35) and the circuit carrier (2) in the region of the reservoir (15, 21, 27, 28, 33, 37, 38, 39, 40) is more than double, preferably more than triple, the gap dimension of the gap (17) in the region surrounding the depression forming the reservoir (15, 21, 27, 28, 33, 37, 38, 39, 40).

4. Contact system (1) according to any of the preceding claims,
wherein the gap dimension of the gap (17) in the region of the electrical contact area and/or the thermal contact area (6) is up to 150 micrometres.

5. Contact system (1) according to any of the preceding claims,
wherein at least one depression forming a reservoir (15, 21, 27, 28, 33, 37, 38, 39, 40) is formed as a longitudinally extending trench.

6. Contact system (1) according to Claim 5,
wherein at least two longitudinally extending trenches each forming a reservoir (15, 21, 27, 28, 33, 37, 38, 39, 40) extend parallel to one another in the plane of the electrical contact area and/or the thermal contact area (6).

7. Contact system (1) according to Claim 5 or 6,
wherein at least two trenches each forming a reservoir (27, 28) in a planar extent of the electrical contact area and/or the thermal contact area (6) are formed, which trenches cross one another.

8. Contact system (1) according to any of Claims 5 to 7,
wherein a grid pattern is formed by the trenches that each form a reservoir (27, 28).

9. Contact system (1) according to any of the preceding claims,
wherein at least one depression forming a reservoir (15, 21, 27, 28, 33, 37, 38, 39, 40) is formed in the shape of a spherical cap or in a cylindrical fashion.

10. Contact system (1) according to any of the preceding claims,
wherein at least one depression forming a reservoir (37, 38, 39, 40) is formed in a curve-shaped or circular fashion.

11. Contact system (1) according to any of the preceding claims,
wherein at least one via (7) is thermally conductively connected to a heat sink (10) arranged on an opposite side of the circuit carrier (2) relative to the component (5).

12. Electrical and/or electronic component (5, 19, 25, 31, 35), in particular semiconductor component, for a contact system (1) according to any of the preceding claims,
wherein the component (5, 19, 25, 31, 35) comprises an electrical contact area and/or thermal contact area (6) formed in particular in a planar fashion for dissipating heat loss to a heat sink, in particular a circuit carrier (2), and at least one depression or recess forming a reservoir (15, 21, 27, 28, 33, 37, 38, 39, 40) is formed at the electrical contact area and/or the thermal contact area (6), such that a gap (17) extending between the electrical contact area and/or the thermal contact area (6) and the circuit carrier (2), in particular a surface of the circuit carrier (2), and serving for guiding a solder is formed such that it is larger in the region of the depression than in a region surrounding the depression.

## Revendications

1. Système de contact (1) comprenant un porte-circuit (2), le porte-circuit (2) possédant au moins une couche de substrat (3) et au moins une couche électriquement conductrice (4, 11), le système de contact (1) possédant au moins un composant électrique et/ou électronique, notamment un composant semiconducteur (5, 19, 25, 31, 35), relié au porte-circuit (2), une surface de contact électrique et/ou une surface de contact thermique (6) du composant (5) étant reliée par fusion de matières au porte-circuit (2), notamment à la couche électriquement conductrice (4), au moyen d'une brasure (14), et la couche électriquement conductrice (4) étant reliée électriquement à au moins un contact à trou d'interconnexion (7) recouvert par la surface de contact électrique et/ou la surface de contact thermique (6), **caractérisé en ce que**
le composant (5, 19, 25, 31, 35) possède au moins une empreinte ou une cavité formant un réservoir (15, 21, 27, 28, 33, 37, 38, 39, 40) au niveau de la surface de contact électrique et/ou de la surface de contact thermique (6), une fente (17) guidant une brasure (14), qui s'étend entre la surface de contact électrique et/ou la surface de contact thermique (6) et le porte-circuit (2), étant configurée plus grande dans la zone du réservoir (15, 21, 27, 28, 33, 37, 38, 39, 40) que dans une zone qui entoure le réservoir (15, 21, 27, 28, 33, 37, 38, 39, 40) et un diamètre transversal (42) d'une ouverture du contact à trou d'interconnexion (7) étant plus grand qu'une cote d'interstice de la fente à brasure dans la zone du réservoir (15, 21, 27, 28, 33, 37, 38, 39, 40).

2. Système de contact (1) selon la revendication 1, le diamètre transversal du trou d'interconnexion (7) étant compris entre 300 et 700 micromètres.

3. Système de contact (1) selon la revendication 1 ou 2, la cote d'interstice d'une fente (16) qui s'étend entre le composant (5, 19, 25, 31, 35) et le porte-circuit (2) dans la zone du réservoir (15, 21, 27, 28, 33, 37, 38, 39, 40) étant égale à plus du double, de préférence plus du triple de la cote d'interstice de la fente (17) dans la zone qui entoure l'empreinte qui forme le réservoir (15, 21, 27, 28, 33, 37, 38, 39, 40).

4. Système de contact (1) selon l'une des revendications précédentes, la cote d'interstice de la fente (17) dans la zone de la surface de contact électrique et/ou de la surface de contact thermique (6) étant égale au maximum à 150 micromètres.

5. Système de contact (1) selon l'une des revendications précédentes, au moins une empreinte qui forme un réservoir (15, 21, 27, 28, 33, 37, 38, 39, 40) étant réalisée sous la forme d'une tranchée étendue en longueur.

6. Système de contact (1) selon la revendication 5, au moins deux tranchées étendues en longueur qui forment respectivement un réservoir (15, 21, 27, 28, 33, 37, 38, 39, 40) s'étendant parallèlement l'une à l'autre dans un plan de la zone de la surface de contact électrique et/ou de la surface de contact thermique (6).

7. Système de contact (1) selon la revendication 5 ou 6, au moins deux tranchées qui forment respectivement un réservoir (27, 28) dans une projection plane de la surface de contact électrique et/ou de la surface de contact thermique (6) se croisant mutuellement.

8. Système de contact (1) selon l'une des revendications 5 à 7, un motif de grille étant formé par les tranchées qui forment respectivement un réservoir (27, 28).

9. Système de contact (1) selon l'une des revendications précédentes, au moins une empreinte qui forme un réservoir (15, 21, 27, 28, 33, 37; 38, 39, 40) étant réalisée en forme de calotte ou en forme de cylindre.

10. Système de contact (1) selon l'une des revendications précédentes, au moins une empreinte qui forme un réservoir (37, 38, 39, 40) étant réalisée en forme de courbe ou en forme de cercle.

11. Système de contact (1) selon l'une des revendications précédentes, au moins un trou d'interconnexion (7) étant relié de manière thermoconductrice à un dissipateur thermique (10) qui est disposé sur un côté du porte-circuit (2) à l'opposé du composant (5).

12. Composant électrique et/ou électronique, notamment composant semiconducteur (5, 19, 25, 31, 35), pour un système de contact (1) selon l'une des revendications précédentes, le composant (5, 19, 25, 31, 35) possédant une surface de contact électrique et/ou une surface de contact thermique (6) de configuration notamment plane destinée à évacuer les pertes thermiques au niveau d'un dissipateur thermique, notamment d'un porte-circuit (2) et au moins une empreinte ou une cavité formant un réservoir (15, 21, 27, 28, 33, 37, 38, 39, 40) étant formée au niveau de la surface de contact électrique et/ou de la surface de contact thermique (6), de sorte qu'une fente (17) destinée à guider une brasure et qui s'étend entre la surface de contact électrique et/ou la surface de contact thermique (6) et le porte-circuit (2), notamment une surface du porte-circuit (2), est réalisée plus grande dans la zone de l'empreinte que dans une zone qui entoure l'empreinte.
